# EUROPÄISCHE PATENTSCHRIFT

(11) **EP 1 806 037 B1**
(45) Veröffentlichungstag und Bekanntmachung des Hinweises auf die Patenterteilung: **17.02.2010**
(21) Anmeldenummer: 05798456.9
(22) Anmeldetag: 05.10.2005
(51) Int. Cl.: H05K 3/02, H05K 1/03, H05K 13/00, H01L 23/373, C04B 37/02

(54) **VERFAHREN ZUM HERSTELLEN EINES METALL-KERAMIK-SUBSTRATES BZW. KUPFER-KERAMIK-SUBSTRATES SOWIE TRÄGER ZUR VERWENDUNG BEI DIESEM VERFAHREN**
METHOD FOR THE PRODUCTION OF A METAL-CERAMIC SUBSTRATE OR COPPER-CERAMIC SUBSTRATE, AND SUPPORT TO BE USED IN SAID METHOD
PROCEDE POUR REALISER UN SUBSTRAT METAL-CERAMIQUE OU UN SUBSTRAT CUIVRE-CERAMIQUE, ET SUPPORT A UTILISER DANS LE CADRE DE CE PROCEDE

(30) Priorität: 27.10.2004 DE 102004052280; 25.11.2004 DE 102004056879
(43) Veröffentlichungstag der Anmeldung: 11.07.2007
(73) Patentinhaber: Curamik Electronics GmbH, 92676 Eschenbach (DE)
(72) Erfinder: SCHULZ-HARDER, Jürgen, 91207 Lauf (DE); FRISCHMANN, Andreas Karl, A-1230 Wien (AT); ROGG, Alexander, 92724 Trabitz (DE); EXEL, Karl, 64668 Rimbach (DE)
(74) Vertreter: Graf, Helmut
(86) Internationale Anmeldenummer: PCT/DE2005/001781
(87) Internationale Veröffentlichungsnummer: WO 2006/045267

(56) Entgegenhaltungen:
- US-A- 4 259 061
- US-A- 4 483 810
- US-A- 4 906 509
- US-A- 5 603 875
- US-A- 6 033 787
- US-A- 6 086 990
- US-A1- 2004 026 482
- US-A1- 2004 131 832

## Beschreibung

Die Erfindung bezieht sich auf ein Verfahren gemäß Oberbegriff Patentanspruch 1.

Bekannt ist es, die zum Herstellen von Leiterbahnen, Anschlüssen usw. benötigte Metallisierung auf einer Keramik, z.B. auf einer Aluminium-Oxid-Keramik mit Hilfe des sogenannten Direct-Bonding-Verfahren und bei Verwendung von Kupfer als Metallisierung auch "DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmetzschicht bzw. Oxidschicht.

Dieses DCB-Verfahren weist dann z.B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozess- bzw. Bondtemperatur zwischen etwa 1025 bis 1083°C, z.B. auf ca. 1072°C;
- Abkühlen auf Raumtemperatur.

Bekannt ist speziell auch (US-A-4,483,810), bei der Herstellung von Metall-Keramik-Substraten mit Hilfe des DCB-Prozesses das jeweilige aus einer Keramikschicht und einer Metallschicht bestehende DCB-Substrat auf einem hitzebeständigem Träger in Form eines Transportbandes durch einen Tunnelofen zu bewegen.

Bekannt ist weiterhin ein Träger aus einem hitzebeständigen Material, der (Träger) als Auflage für das Brennen von grüner Keramik dient und mit einer Trennschicht an einer Oberflächenseite versehen ist(US-A-4,259,061). Die Trennschicht besteht aus Aluminiumoxid (Al₂O₃) und besitzt eine Dicke im Bereich zwischen 0,08 bis 0,125mm.

Bekannt sind insbesondere auch doppelseitig metallisierte Metall-Keramik-Substrate bzw. Kupfer-Keramik-Substrate (US-A-6033787, UA-A-2004/0131832), die dann dadurch hergestellt werden, dass unter Verwendung des DCB-Verfahrens zunächst auf eine Oberflächenseite einer Keramikschicht oder einer Keramikplatte eine erste Kupferschicht und dann in einem zweiten Arbeitsgang eine zweite Kupferschicht auf die andere Oberflächenseite aufgebracht werden. Nachteilig hierbei ist der durch das zweifache DCB-Bonden bedingte erhöhte Fertigungsaufwand.

Aufgabe der Erfindung ist es, ein Verfahren aufzuzeigen, mit der die Herstellung von doppelseitig metallisierten Metall-Keramik-Substraten und dabei insbesondere auch von doppelseitig metallisierten Kupfer-Keramik-Substraten in einem einzigen Arbeitsverfahren bzw. Bond-Schritt möglich ist. Zur Lösung dieser Aufgabe ist ein Verfahren entsprechend dem Patentanspruch 1 ausgebildet.

Als Prozesshilfsmittel wird bei diesem Verfahren zumindest ein vorzugsweise als Tragplatte ausgebildeter Träger verwendet, der an wenigstens einer Oberflächenseite mit einer Trennschicht derart versehen ist, dass während des DCB-Bondens eine Verbindung des an dieser Trennschicht anliegenden Metalls bzw. Kupfers mit dem Träger nicht eintritt. Hierdurch ist es möglich, auf der Trennschicht jeweils ein Paket (nachfolgend auch "DCB-Paket") bestehend aus einer untenliegenden, der Trennschicht unmittelbar benachbarten ersten Metallschicht oder -platte, aus einer darüber angeordneten Keramikschicht oder -platte und aus einer darüber angeordneten weiteren Metallschicht oder -platte vorzusehen und dieses DCB-Paket dann durch DCB-Bonden in einer Schutzgasatmosphäre mit geringem Sauerstoffanteil und durch Erhitzen auf die Bond-Temperatur (beispielsweise etwa 1072°C) zu dem doppelseitig metallisierten Metall-Keramik-Substrat zu verbinden.

Weiterbildungen der Erfindung sind Gegenstand der Unteransprüche.

Die Erfindung wird im Folgenden anhand der Figuren, die in schematischer Darstellung verschiedene Methoden zum Herstellen von Metall-Keramik-Substraten unter Verwendung der DCB-Technik bzw. des DCB-Verfahrens zeigen, näher erläutert.

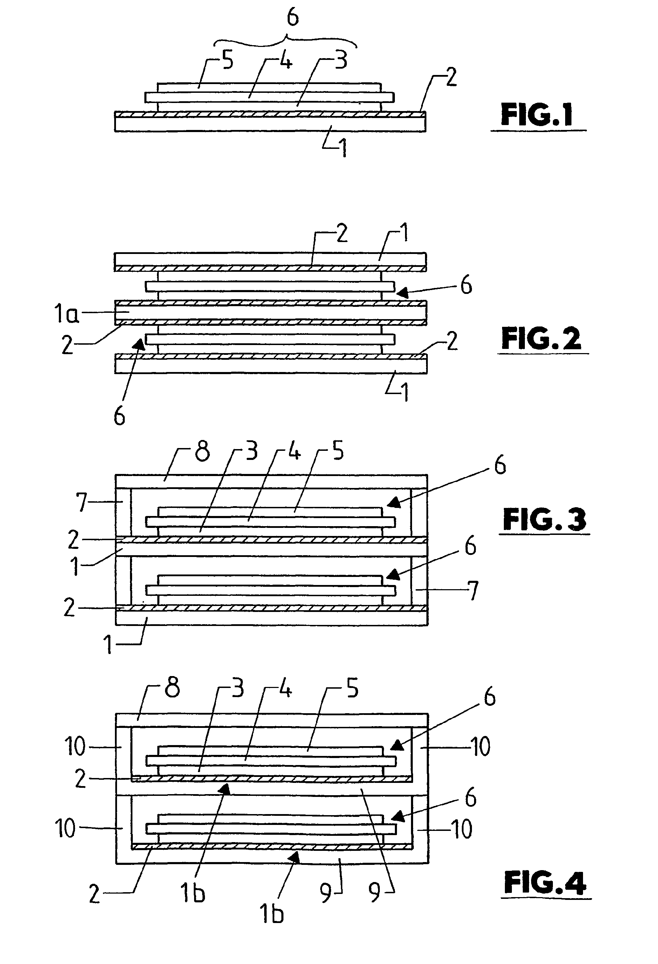

In der Fig. 1 ist 1 eine als Produktionshilfsmittel bei der Herstellung eines Kupfer-Keramik-Substrates verwendete Tragplatte, die aus einem Material hoher Hitzebeständigkeit besteht, beispielsweise aus Mullit, ZrO₂ Al₂O₃, AIN, Si₃N₄, SiC. Die Platte 1 ist an ihrer Oberseite mit einer porösen Trennschicht 2 versehen, die eine Dicke im Bereich zwischen 0,01 und 10 mm aufweist und deren Porosität (Verhältnis des Porenvolumens zu dem Feststoffvolumen) größer als 20% ist. Die Schicht 2 besteht aus feinsten Partikeln oder aus einem Pulver aus einem hochtemperaturfesten Material, beispielsweise aus Mullit, Al₂O₃, TiO₂, ZrO₂, MgO, CaO, CaCO₂ und mit einer Korngröße beispielsweise kleiner als 30 µm. Auch Mischungen zweier oder mehrerer der vorgenannten Materialien oder Komponenten sind für die Trennschicht 2 geeignet.

Zum Herstellen der Trennschicht 2 wird beispielsweise eine breiartige Masse oder Suspension verwendet, die in einer flüssigen oder pasteusen Matrix, die im einfachsten Fall aus Wasser, ggf. mit einem Bindemittel besteht, auf die betreffende Oberflächenseite der Tragplatte 1 aufgebracht, und zwar beispielsweise durch Aufrakeln oder Tauchen. Anschließend erfolgt durch Erhitzen ein Trocknen und/oder Entfernen des Bindemittels und zwar bei einer Vorbehandlungstemperatur beispielsweise größer 150°C. Anschließend kann beispielsweise bei einer höheren Temperatur, die aber unter der Sintertemperatur des für die Schicht verwendeten Materials liegt, z.B. bei einer Temperatur von etwa 1070° C ein gewisses "Verbacken" oder Verbinden der die Schicht 2 bildenden Partikel in der Weise erfolgen, dass diese Schicht 2 mit der hohen Porosität < 20% erreicht ist.

Die Tragplatte 1 besitzt eine Dicke im Bereich zwischen 0,2 - 10 mm. An die Ebenheit der Tragplatte 1 und damit des von dieser Tragplatte und der Trennschicht 2 gebildeten Fertigungshilfsmittels sind besonders hohe Anforderungen gestellt, um die erforderlich Qualität für die hergestellten Metall-Keramik-Substrate zu erreichen. Die Ebenheit ist daher größer 0,2% der Länge der beispielsweise rechteckförmig ausgebildeten Tragplatte 1 und auf jeden Fall auch größer 0,1 % der Breite dieser Tragplatte, d.h. Abweichungen von einer idealen, absolut ebenen Platte sind kleiner 0,2% der Plattenlänge und auch kleiner 0,1 % der Plattenbreite.

Für die Herstellung eines doppelseitig mit einer Kupfer-Metallisierung versehenen Kupfer-Keramik-Substrates unter Verwendung der DCB-Technik wird entsprechend der Fig. 1 auf die Trennschicht 2 der horizontal angeordneten Tragplatte 1 zunächst eine erste beispielsweise voroxidierte Kupferfolie oder -platte 3, anschließend eine Keramikschicht oder -platte 4 und daran anschließend eine weitere beispielsweise voroxidierte Kupferfolie oder -platte 5 aufgelegt. Das so auf der Tragplatte 1 gebildete DCB-Paket 6 wird dann auf der Tragplatte 1 in einer sauerstoffarmen Schutzgasatmosphäre auf die DCB-Temperatur, beispielsweise auf 1070° C erhitzt, so dass dann nach dem DCB-Prozess die beiden Kupferfolien 3 und 5 jeweils vollflächig mit der Keramikschicht zu dem Kupfer-Keramik-Substrat verbunden sind. Das so in einem Arbeitsprozess hergestellte beidseitig metallisierte Kupfer-Keramik-Substrat kann nach dem Abkühlen problemlos von der Tragplatte 1 bzw. von der dortigen Trennschicht 2 abgenommen werden. Eventuell an der von der Kupferfolie 3 gebildeten Kupferschicht anhaftende Partikel der Trennschicht 2 werden dann anschließend mit einem geeigneten Verfahren entfernt. Hierfür eignen sich z.B. mechanische Verfahren, wie beispielsweise Abbürsten, oder chemische Verfahren, wie beispielsweise Abätzen einer dünnen Oberflächenschicht der von der Kupferfolie 3 gebildeten Metallisierung. Auch Kombinationen derartiger Reinigungsverfahren sind denkbar.

Die Fig. 2 zeigt als weitere mögliche Ausführungsform ein Verfahren, bei dem mehrere, jeweils doppelseitig metallisierte Kupfer-Keramik-Substrate im Stapel in einem Arbeitsgang mittels des DCB-Prozesses gefertigt werden. Hierfür werden zwei Tragplatten 1 mit jeweils einer porösen Trennschicht 2 verwendet sowie wenigstens eine weitere Tragplatte 1a, die an beiden Oberlfächenseiten mit der porösen Trennschicht 2 versehen ist.

Wie dargestellt, wird auf die untere, wiederum horizontal angeordnete Tragplatte 1 bzw. auf deren Trennschicht 2 ein DCB-Paket 6 aus dem unteren Kupferfolie 3, aus der Keramikschicht 4 und der oberen Kupferfolie 5 gebildet. Auf dieses DCB-Paket 6 wird dann die Trag- oder Zwischenplatte 1 a mit einer die Trennschicht 2 aufweisenden Oberflächenseite aufgelegt. Auf die dann oben liegende andere Trennschicht 2 der Tragplatte 1 a wird ein weiteres DCB-Paket 6 aufgebracht, auf das dann bei der Darstellung der Fig. 2 die obere Tragplatte 1 als Beschwerungsplatte aufgelegt wird, und zwar derart, dass sich diese mit ihrer Trennschicht 2 auf dem oberen DCB-Paket 6 abstützt. Grundsätzlich besteht bei dieser Ausführung auch die Möglichkeit, mehr als zwei DCB-Pakete 6 mit dazwischenliegenden Trag- oder Trennplatten 1a vorzusehen.

Nach der Durchführung des DCB-Prozesses, d.h. nach dem Erhitzen der aus den DCB-Paketen 6 und den Tragplatten 1/1 a bestehenden Anordnung auf die DCB- oder Bond-Temperatur und nach dem Abkühlen können die aus den DCB-Paketen 6 erhaltenen, doppelseitig metallisierten Kupfer-Keramik-Substrate wieder von den Tragplatten 1 bzw. 1a abgenommen werden, wobei auch bei dieser Ausführung die Trennschichten 2 ein unerwünschtes Verbinden der Kupferfolien 3 und 5 mit der jeweils benachbarten Tragplatte 1 bzw. 1a verhindern.

Die Fig. 3 zeigt als weitere grundsätzliche Ausführungsform ein Verfahren, bei dem die Kupferfolien 3 und 5 und die Keramikschicht 4 mehrerer, stapelartig übereinander angeordneter DCB-Pakete 6 in einem Arbeitsgang jeweils zu einem doppelseitig metallisierten Kupfer-Keramik-Substrat verbunden werden. Verwendet sind bei der in der Fig. 3 dargestellten Ausführungsform zwei horizontale Tragplatten 1, die parallel zueinander übereinander angeordnet sind. Zur Beabstandung der beiden Tragplatten 1 dient ein beispielsweise rahmenartiger Abstandhalter 7, der ebenfalls aus einem hochtemperaturfesten Material, vorzugsweise aus dem Material besteht, welches auch für die Tragplatten 1 verwendet ist. Auf die bei jeder Tragplatte 1 oben liegende horizontale Trennschicht 2 ist jeweils ein DCB-Paket 6 aufgelegt. Oberhalb des oberen DCB-Paketes 6 und durch einen Abstandhalter 7 von der oberen Tragplatte 1 beabstandet befindet sich eine obere Abschlussplatte 8, die ebenfalls aus dem hochtemperaturfesten Material besteht, beispielsweise aus dem Material der Tragplatten 1. Die Abstandhalter 7 sind so ausgeführt, dass die Oberseite des unteren DCB-Paketes 6 von der darüber liegenden Tragplatte 1 und die Oberseite des oberen DCB-Paketes 6 von der darüber liegenden Abschlussplatte 8 beabstandet ist.

Auch bei dieser Ausführung ist ein problemloses Abnehmen des hergestellten doppelseitig metallisierten Kupfer-Keramik-Substrates nach Abschluss des DCB-Prozesses möglich.

Die Fig. 4 zeigt als weitere Ausführungsform eine Anordnung, bei der anstelle der Tragplatten 1 und Abstandhalter 7 rechteckförmige oder quadratische Tragplatten 1 b verwendet sind, die an wenigstens zwei einander gegenüberliegenden Seiten jeweils mit einem als Abstandhalter wirkenden Wandabschnitte oder überstehenden Rand 9 versehen sind, die über einen Boden 10 vorstehen. Die Innenseite dieser wannen- oder rinnenartigen Tragplatten 1 b ist zumindest am Boden 10 mit der Trennschicht 2 versehen. Durch Übereinanderstapeln der Tragplatten 1b können wiederum mehrere DCB-Pakete 6 in einem Verfahrensschritt zu jeweils einem doppelseitig metallisierten Kupfer-Keramik-Substrat gebondet werden.

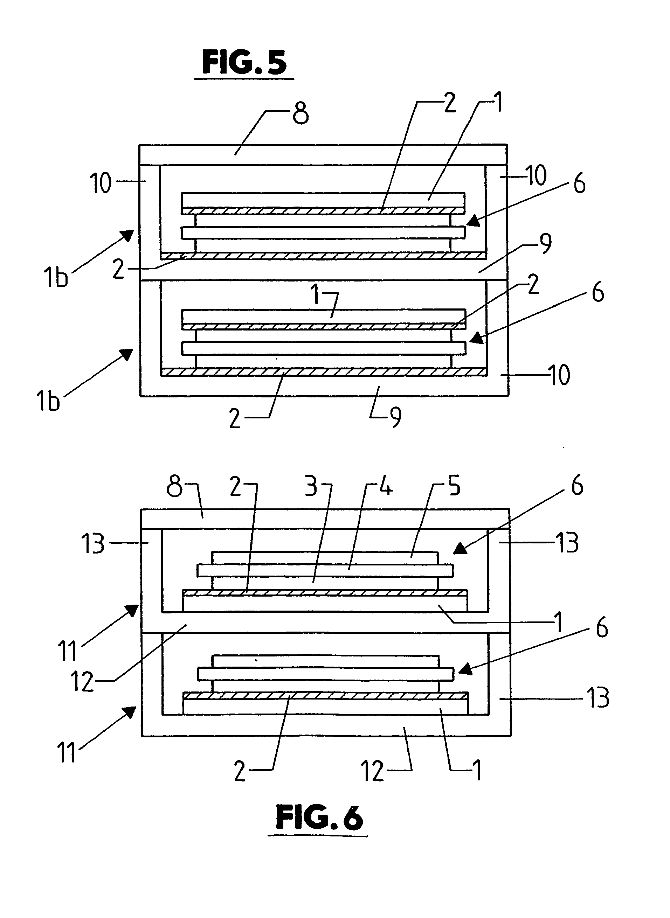

Die Fig. 5 zeigt eine Anordnung, die sich von der Anordnung der Fig. 4 im wesentlichen nur dadurch unterscheidet, dass auf jedem DCB-Paket 6 zusätzlich als Beschwerungsplatte noch eine weitere Tragplatte 1 aufliegt, und zwar mit der Trennschicht 2 unten liegend, d.h. zwischen dieser weiteren Tragplatte und dem betreffenden DCB-Paket. Ebenso wie bei der Ausführung der Fig. 4 können auch bei der Ausführung der Fig. 5 mehr als zwei Tragplatten 1b übereinander gestapelt vorgesehen sein.

Die Fig. 6 zeigt als weitere mögliche Ausführungsform eine Anordnung, bei der anstelle der wannen- oder rinnenartigen Tragplatten 1b mit der innenliegenden Trennschicht 2 rinnen- oder wannenartige Hilfs- oder Tragelemente 11 verwendet sind, die wiederum aus einem quadratischen oder rechteckförmigen, plattenartigen Boden 12 und aus einstückig mit diesem Boden gefertigten Wänden 13 bestehen, welche an wenigstens zwei einander gegenüberliegenden Seiten des Bodens 12 über eine gemeinsame Oberflächenseite dieses Bodens wegstehen und Abstandhalter bilden, so dass die Tragelemente 11 übereinander gestapelt mit ihrem Boden 12 jeweils ausreichend beabstandet sind.

Für die Herstellung mehrerer doppelseitig metallisierter Kupfer-Keramik-Substrate wird in jedes Tragelement 11 eine Tragplatte 1 derart eingelegt, dass das betreffende DCB-Paket 6 dann auf die Trennschicht 2 aufgelegt werden kann. Im Anschluss daran wird das nächste Tragelement 11 auf die Ränder 13 des darunter liegenden Tragelementes 11 aufgesetzt und dann auf die in dieses Tragelement eingesetzte Tragplatte 1 bzw. deren Trennschicht 2 ein weiteres DCB-Paket aufgesetzt usw. Das obere Tragelement 11 wird wiederum durch eine Abschlussplatte 8 abgedeckt.

Die Ausführungen der Figuren 3 bis 6 haben den Vorteil, dass insbesondere auch die in der Stapelanordnung unten liegenden DCB-Pakete 6 nicht durch das Gewicht darüber liegender DCB-Pakete 6 belastet sind und somit das DCB-Bonden bei allen DCB-Paketen 6 reproduzierbar mit derselben Qualität und unter denselben Bedingungen durchgeführt werden kann. Weiterhin besteht bei diesen Ausführungen die Möglichkeit, den Sauerstoffgehalt der die DCB-Pakete innerhalb der Stapelanordnung umgebenden Schutzgasatmosphäre während des DCB-Prozesses optimal einzustellen, und zwar beispielsweise dadurch, dass die Abstandhalter 7 mit Fenstern definierter Größe versehen werden, über die die zwischen den Abstandhaltern 7 und den Platten 1 bzw. 8 gebildeten Räume mit der die Stapelanordnung während des DCB-Prozesses umgebenden Schutzgasatmosphäre in Verbindung stehen.

Bei den vorbeschriebenen Ausführungsformen weist die Keramikschicht beispielsweise eine Größe größer 100 x 100 mm auf, wobei die Abmessungen der die Kupferlagen oder -platten 3 und 5 bildenden Zuschnitte der Kupferfolie etwa in der gleichen Größenordnung liegen. Für die Keramikschicht 4 eignet sich beispielsweise auch eine Aluminiumoxid-Keramik (Al₂O₃) mit einem Anteil an Zirkonoxid (ZrO₂ in der Größenordnung von etwa 2 - 30% oder eine Aluminiumnitrid-Keramik, beispielsweise mit Itrium als Zusatz oder eine Siliziumnitrid-Keramik, wobei die Aluminiumnitrid-Keramik und/oder die Siliziumnitrid-Keramik beispielsweise eine oxidische Oberflächenschicht, beispielsweise eine Oberflächenschicht aus Aluminiumoxid aufweist. Die Dicke der Keramikschicht 4 liegt im Bereich zwischen 0,2 und 1,5 mm. Die Dicke der die Kupferschichten bildenden Folie etwa im Bereich zwischen 0,1 und 1,2 mm. Weiterhin besteht bei den oben beschriebenen Ausführungen auch grundsätzlich die Möglichkeit, dass die Dicke der Kupferschichten 3 und 5 unterschiedlich ist, wobei das Verhältnis Dicke der Kupferschicht zur Dicke der Keramikschicht 4 vorzugsweise größer als 0,5 ist.

In der nachfolgenden Tabelle sind vorteilhafte Beispiele für die Schichtdicken der Keramikschicht 4 und der Kupferschichten 3 und 5 wieder gegeben.

| Paarung Keramikschichtdicke /Kupferschichtdicke Nr. | Dicke der Keramikschicht 4 in mm | Dicke der Kupferschicht 3 bzw. 5 in mm |
|---|---|---|
| 1 | 0,5 | 0,3 |
| 2 | 0,32 | 0,4 |
| 3 | 0,5 | 0,4 |
| 4 | 0,63 | 0,6 |
| 5 | 0,25 | 0,4 |

Bei einer bevorzugten Ausführungsform ist der thermische Ausdehnungskoeffizient der jeweiligen Tragplatte 1, 1a, 1b unterschiedlich von dem thermischen Ausdehnungskoeffizienten der Keramikschicht 4, beispielsweise um wenigstens +/ 10%.

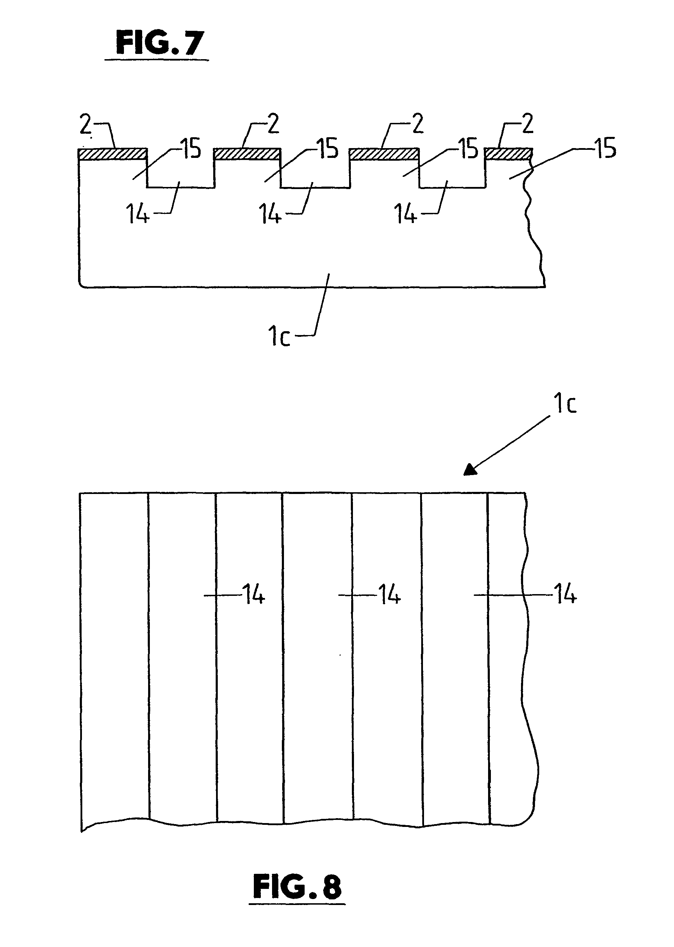

Die Figuren 7 und 8 zeigen in vereinfachter Darstellung und im Schnitt sowie in Draufsicht eine Tragplatte 1c, die an einer Oberflächenseite strukturiert ist, d.h. mit einer Vielzahl von parallel zueinander und parallel zu zwei Umfangsseiten der rechteckförmigen oder quadratischen Tragplatte 1c verlaufenden und voneinander beabstandeten Vertiefungen oder Nuten 14 versehen ist. Die Trennschicht 2 ist bei dieser Ausführungsform auf den zwischen den Nuten 14 gebildeten Erhebungen 15 vorgesehen. Im Verwendungsfall liegt das jeweilige DCB-Paket 6 bzw. die jeweilige Kupferplatte 3 bzw. 5 lediglich gegen die Erhebungen 15 an.

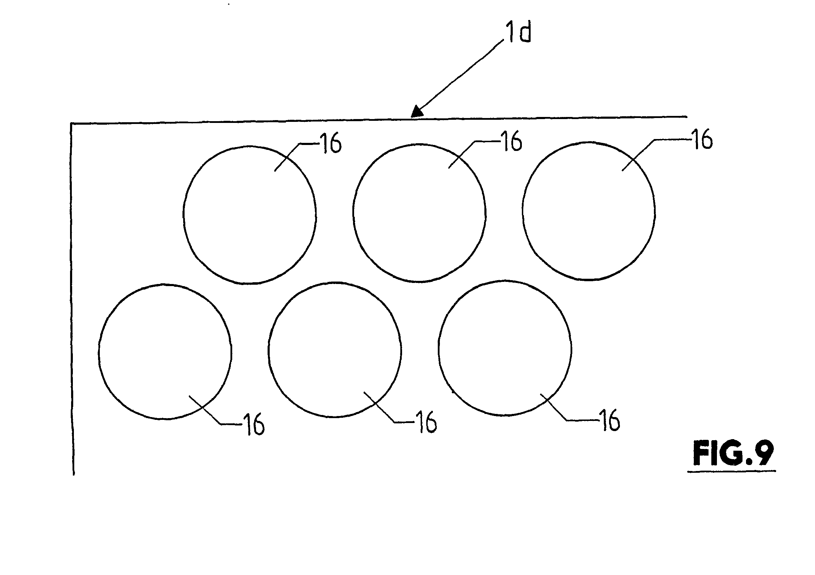

Anstelle der nutenartigen Vertiefungen 14 können an der Tragplatte auch andere Vertiefungen 16 vorgesehen sein, beispielsweise kreisförmige Vertiefungen, wie dies in der Fig. 9 für die Tragplatte 1d dargestellt ist. Auch bei dieser Ausführungsform bilden lediglich die erhabenen Bereiche zwischen den Vertiefungen 16 Anlageflächen der Tragplatte 1d und sind mit der Trennschicht 2 versehen. Weiterhin besteht die Möglichkeit, die jeweilige Tragplatte an beiden Oberflächenseiten zu profilieren, insbesondere dann, wenn diese Tragplatte als Zwischenplatte verwendet wird.

Zur weiteren Erläuterung der Erfindung dienen die nachstehenden Beispiele:

### Beispiel 1

Zwei Kupferschichten oder Kupferplatten 3 und 5 mit den Abmessungen 130 x 180 mm und mit einer Dicke von 0,4 mm werden beidseitig mit einer Oxidschicht versehen.

Eine Keramikplatte 4 aus Al₂O₃ mit der Abmessung von 130 x 180mm und mit einer Dicke von 0,32 mm wird gereinigt, beispielsweise durch Bürsten. Der thermische Ausdehnungskoeffizient der Keramikplatte beträgt 6,8 x 10⁻⁶/° K.

Die Ebenheit der Keramikplatte 4 wird mittels zweier planparalleler Platten gemessen und die Abweichungen von einer absolut ebenen Keramikplatte sind kleiner als 0,5 mm.

Auf eine Tragplatte 1 aus Mullit mit einer Dicke von 3mm wird zur Bildung der Trennschicht 2 eine Schicht aus einem pulverförmigen Al₂O₃-Material mit einer mittleren Körnung von 10 µm als wässrige Suspension durch Aufrakeln aufgebracht, und zwar mit einer Schichtdicke von etwa 1 mm.

Die Tragplatte wird dann bei 150° C getrocknet.

Auf die getrocknete Tragplatte wird ein DCB-Paket 6 aufgebracht, d.h. als unterste Lage zunächst die voroxidierte Kupferplatte 3 darauf die Keramikplatte 4 und darauf die zweite, voroxidierte Kupferplatte 5.

Die so gebildete Stapelanordnung wird dann in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Die Stapelanordnung wird dann dem Ofen entnommen und nach ausreichendem Abkühlen wird das erhaltene, beidseitig metallisierte DCB- oder Kupfer-Keramik-Substrat von der Tragplatte getrennt.

Die freiliegenden Kupferoberflächen werden durch Bürsten von anhaftenden Keramikpartikeln der Trennschicht gereinigt.

### Beispiel 2

Zwei Kupferplatten 3 und 5 mit der Abmessung von 130 x 180 mm und mit einer Dicke von 0,4 mm werden mit einer Oxidschicht versehen bzw. voroxidiert.

Eine Keramikplatte 4 aus Al₂O₃ mit einer Dicke von 0,63mm und mit Abmessungen von 130 x 180mm wird durch Bürsten gereinigt. Der Ausdehnungskoeffizient der Al₂O₃ -Platte beträgt 6,8 x 10⁻⁶/° K.

Die Ebenheit der Keramikplatte 4 wird mittels zweier planparalleler Platten gemessen und die Abweichungen von einer absolut ebenen Keramikplatte sind kleiner als 0,8 mm.

Auf eine Tragplatte 1 aus Mullit mit einer Dicke von 3mm wird zur Bildung der Trennschicht 2 eine Schicht aus einem pulverförmigen Al₁O₃ -Material mit einer mittleren Körnung von 10 µm als wässrige Suspension durch Aufrakeln aufgebracht, und zwar mit einer Schichtdicke von etwa 1 mm.

Auf eine weitere Tragplatte 1 (als Beschwerungsplatte) aus Mullit mit einer Dicke von 4mm wird zur Bildung der Trennschicht 2 eine Schicht aus einem pulverförmigen Al₂O₃ -Material mit einer mittleren Körnung von 10 µm als wässrige Suspension durch Aufrakeln aufgebracht, und zwar mit einer Schichtdicke von etwa 1 mm.

Die Tragplatten werden dann bei 150° C getrocknet.

Auf die getrocknete erste Tragplatte 1 wird ein DCB-Paket 6 aufgebracht, d.h. als unterste Lage zunächst die voroxidierte Kupferplatte 3 darauf die Keramikplatte 4 und darauf die zweite, voroxidierte Kupferplatte 5.

Auf das DCB-Paket 6 wird die zweite Tragplatte 1 als Beschwerungsplatte aufgelegt.

Die so gebildete Stapelanordnung wird dann in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Die Stapelanordnung wird dann dem Ofen entnommen und nach ausreichendem Abkühlen wird das erhaltene, beidseitig metallisierte DCB- oder Kupfer-Keramik-Substrat von der Tragplatte getrennt.

Die Kupferoberflächen des Kupfer-Keramik-Substrates werden durch chemisches Ätzen u.a. von anhaftenden Keramikpartikeln der Trennschicht gereinigt.

### Beispiel 3

Bei diesem Verfahren erfolgt die Vorgehensweise wie bei dem Beispiel 1 oder beim Beispiel 2, allerdings mit dem Unterschied, dass insgesamt drei Tragplatten aus Mullit vorbereitet werden, und zwar beispielsweise zwei Tragplatten 1 und 1a jeweils mit einer Dicke von 3mm und eine Tragplatte 1 (als Beschwerungsplatte) mit einer Dicke von 4mm.

Auf eine Oberflächenseite einer der Tragplatten 1 mit einer Dicke von 3 mm wird zur Erzeugung der Trennschicht 2 eine Schicht aus dem pulverförmigen Al₂O₃ - Material als wässrige Suspension bzw. Masse durch Aufrakeln mit einer Dicke von 1 mm aufgebracht.

Auf die andere Tragplatte 1a mit der Dicke von 3mm wird auf beide Oberflächenseiten jeweils die Schicht aus dem pulverförmigen Al₂O₃ -Material mit der Dicke von 1 mm aufgebracht, und zwar zur Bildung einer Zwischenplatte.

Auf wenigstens einer Oberflächenseite der dritten Tragplatte 1 mit der Dicke von 4mm (Beschwerungsplatte) wird zur Bildung der Trennschicht die wässrige Suspension oder Masse aus dem pulverförmigen Al₂O₃ -Material durch Aufrakeln mit einer Schichtdicke von 1 mm aufgebracht.

Die so vorbereiteten Tragplatten 1 und 1a werden dann bei jeweils 150° C getrocknet und unter Verwendung dieser Tragplatten wird die in der Fig. 2 dargestellte Stapelanordnung gebildet.

Die Stapelanordnung wird dann in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Die Stapelanordnung wird dann dem Ofen entnommen und nach ausreichendem Abkühlen wird das erhaltene, beidseitig metallisierte DCB- oder Kupfer-Keramik-Substrat von der Tragplatte getrennt.

Die Kupferoberflächen des Kupfer-Keramik-Substrates werden durch Abbürsten und/oder chemisches Ätzen u.a. von anhaftenden Keramikpartikeln der Trennschicht gereinigt.

### Beispiel 4

Zwei Kupferschichten oder Kupferplatten 3 und 5 mit den Abmessungen 130 x 180 mm und mit einer Dicke von 0,4mm werden beidseitig mit einer Oxidschicht versehen.

Eine Keramikplatte 4 aus Al₂O₃ mit der Abmessung von 130 × 180 mm und mit einer Dicke von 0,32mm wird gereinigt, beispielsweise durch Bürsten. Der thermische Ausdehnungskoeffizient der Keramikplatte beträgt 6,8 x 10⁻⁶/° K.

Die Ebenheit der Keramikplatte 4 wird mittels zweier planparalleler Platten gemessen und die Abweichungen von einer absolut ebenen Keramikplatte sind kleiner als 0,5 mm.

Eine Tragplatte 1 b aus Mullit mit einer Dicke des Bodens 9 von 3 mm wird zur Erzeugung der Trennschicht 2 an der Innenseite des Bodens 9 mit einer Schicht aus der das pulverförmige Al₂O₃ - Material mit einer mittleren Körnung von 10 µ in enthaltenden wässriger Suspension oder Masse versehen.

Die Tragplatte 1b wird dann bei 150° C getrocknet.

Unter Verwendung der Tragplatte 1b wird dann eine Stapelanordnung ähnlich der Stapelanordnung der Fig. 4 gebildet, allerdings nur mit einer Tragplatte 1b, einem in dieser Tragplatte aufgenommenen DCB-Paket 6 und einer Abdeckplatte 8.

Die Stapelanordnung wird dann in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Die Stapelanordnung wird anschließend dem Ofen entnommen.

Nach ausreichendem Abkühlen wird das erhaltene, beidseitig metallisierte DCB- oder Kupfer-Keramik-Substrat von der Tragplatte getrennt.

Die freiliegenden Kupferoberflächen werden durch Bürsten von anhaftenden Keramikpartikeln der Trennschicht gereinigt.

### Beispiel 5

Dieses Beispiel unterscheidet sich von dem Beispiel 4 dadurch, dass anstelle von nur einer Tragplatte 1b zwei Tragplatten 1b verwendet werden, und zwar zur Bildung einer Stapelanordnung der Fig. 4. Beide Tragplatten 1b werden in der in Beispiel 4 beschriebenen Weise an der Innenseite ihres Bodens 9 jeweils mit einer Trennschicht 2 versehen.

Die Stapelanordnung wird dann in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Die Stapelanordnung wird anschließend dem Ofen entnommen.

Nach ausreichendem Abkühlen wird das erhaltene, beidseitig metallisierte DCB- oder Kupfer-Keramik-Substrat von der Tragplatte getrennt.

Die freiliegenden Kupferoberflächen werden durch Bürsten von anhaftenden Keramikpartikeln der Trennschicht gereinigt.

### Beispiel 6

Die Verfahrensweise dieses Beispiels entspricht dem Beispiel 5, wobei zusätzlich zu den beiden Tragplatten 1b noch zwei weitere Platten 1 aus Mullit mit einer Dicke von 4mm als Beschwerungsplatten verwendet werden. Beide Platten 1 werden jeweils an wenigstens einer Oberflächenseite mit der Trennschicht 2 versehen, und zwar durch Aufbringen der breiartigen oder wässrigen Masse aus dem pulverförmigen Al₂O₃-Material mit einer Schichtdicke von 1 mm.

Nach dem Trocknen der Platten 1 und 1 b wird mit diesen die Stapelanordnung mit zwei DCB-Paketen 6 entsprechend Fig. 6 gebildet.

Die Stapelanordnung wird dann in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Nach dem DCB-Prozess und nach dem Abkühlen werden die erhaltenen DCB- oder Kupfer-Keramik-Substrate entnommen.

Die freiliegenden Oberflächen werden dann durch Bürsten und/oder chemische Behandlung u.a. von anhaftenden Keramikpartikeln gereinigt.

### Beispiel 7

Zwei Kupferplatten 3 und 5 mit der Abmessung von 130 × 180 mm und mit einer Dicke von 0,4mm werden mit einer Oxidschicht versehen bzw. voroxidiert.

Eine Keramikplatte 4 Keramikplatte aus AIN mit einer Dicke von 0,63mm und mit Abmessungen von 130 x 180 mm wird durch Bürsten gereinigt. Der Ausdehnungskoeffizient der AlN-Platte beträgt 4 x 10⁻⁶/° K.

Die Ebenheit der Keramikplatte 4 wird mittels zweier planparalleler Platten gemessen und die Abweichungen von einer absolut ebenen Keramikplatte sind kleiner als 0,8 mm.

Auf eine Tragplatte 1 aus Al₂O₃ mit einem thermischen Ausdehnungskoeffizienten von 6, 8 x 10⁻⁶/° K. und mit einer Dicke von 3mm wird zur Bildung der Trennschicht 2 eine Schicht aus dem pulverförmigen Al₂O₃ -Material mit einer mittleren Körnung von 10 µm als wässrige Suspension durch Aufrakeln aufgebracht, und zwar mit einer Schichtdicke von etwa 1 mm.

Auf eine weitere Tragplatte 1 (als Beschwerungsplatte) aus Al₂O₃ mit einem thermischen Ausdehnungskoeffizienten von 6, 8 x 10⁻⁶/° K. und mit einer Dicke von 4 mm wird zur Bildung der Trennschicht 2 eine Schicht aus einem pulverförmigen Al₂O₃-Material mit einer mittleren Körnung von 10 µm als wässrige Suspension durch Aufrakeln aufgebracht, und zwar mit einer Schichtdicke von etwa 1 mm.

Die Tragplatten werden dann bei 150° C getrocknet.

Auf die getrocknete erste Tragplatte 1 wird ein DCB-Paket 6 aufgebracht, d.h. als unterste Lage zunächst die voroxidierte Kupferplatte 3 darauf die Keramikplatte 4 und darauf die zweite, voroxidierte Kupferplatte 5.

Auf das DCB-Paket 6 wird die zweite Tragplatte 1 als Beschwerungsplatte aufgelegt.

Die so gebildete Stapelanordnung wird dann in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Die Stapelanordnung wird dann dem Ofen entnommen und nach ausreichendem Abkühlen wird das erhaltene, beidseitig metallisierte DCB- oder Kupfer-Keramik-Substrat von der Tragplatte getrennt.

Die Kupferoberflächen des Kupfer-Keramik-Substrates werden durch Bürsten und/oder durch chemisches Ätzen u.a. von anhaftenden Keramikpartikeln der Trennschicht

### Beispiel 8

Zwei Kupferschichten oder Kupferplatten 3 und 5 mit den Abmessungen 130 x 180mm und mit einer Dicke von 0,4mm werden beidseitig mit einer Oxidschicht versehen.

Eine Keramikplatte 4 aus Al₂O₃ mit 20 Gewichtsprozent ZrO₂ und mit Abmessungen von 130 x 180mm sowie mit einer Dicke von 0,32mm wird gereinigt, beispielsweise durch Bürsten. Der thermische Ausdehnungskoeffizient der Keramikplatte beträgt 6,8 x 10⁻⁶/° K.

Die Ebenheit der Keramikplatte 4 wird mittels zweier planparalleler Platten gemessen und die Abweichungen von einer absolut ebenen Keramikplatte sind kleiner als 0,5 mm.

Insgesamt drei Tragplatten aus SiC werden vorbereitet, und zwar zwei Tragplatten 1 und 1a jeweils mit einer Dicke von 3mm und eine Tragplatte 1 (als Beschwerungsplatte) mit einer Dicke von 4mm.

Auf eine Oberflächenseite einer der Tragplatten 1 mit einer Dicke von 3 mm wird zur Erzeugung der Trennschicht 2 eine Schicht aus dem pulverförmigen Al₂O₃-Material als wässrige Suspension bzw. Masse durch Aufrakeln mit einer Dicke von 1 mm aufgebracht.

Auf die andere Tragplatte 1 a mit der Dicke von 3 mm wird auf beide Oberflächenseiten jeweils die Schicht aus dem pulverförmigen Al₂O₃ -Material mit der Dicke von 1 mm aufgebracht, und zwar zur Bildung einer Zwischenplatte.

Auf wenigstens einer Oberflächenseite der dritten Tragplatte 1 mit der Dicke von 4 mm (Beschwerungsplatte) wird zur Bildung der Trennschicht die wässrige Suspension oder Masse aus dem pulverförmigen Al₂O₃ -Material durch Aufrakeln mit einer Schichtdicke von 1 mm aufgebracht.

Die so vorbereiteten Tragplatten 1 und 1a werden dann bei jeweils 150° C getrocknet und unter Verwendung dieser Tragplatten wird die in der Fig. 2 dargestellte Stapelanordnung gebildet.

Die Stapelanordnung wird in einem Ofen in einer Schutzgasatmosphäre, beispielsweise Stickstoffatmosphäre mit einem Sauerstoffanteil von 10 x 10⁻⁶ Volumenprozent auf eine DCB-Temperatur von 1072° C erhitzt.

Die Stapelanordnung wird dann dem Ofen entnommen und nach ausreichendem Abkühlen wird das erhaltene, beidseitig metallisierte DCB- oder Kupfer-Keramik-Substrat von der Tragplatte getrennt.

Die Kupferoberflächen des Kupfer-Keramik-Substrates werden durch Abbürsten und/oder chemisches Ätzen u.a. von anhaftenden Keramikpartikeln der Trennschicht gereinigt.

Vorstehend wurde davon ausgegangen, dass die jeweiligen Trennschichten 2 durch Aufbringen der das pulverförmige Trennschichtenmaterial (beispielsweise Al₂O₃ - Material usw.) in einer flüssigen oder wässrigen Matrix enthaltenden Masse und durch anschließendes Trocknen und/oder Austreiben eines Bindemittels bei einer Temperatur von beispielsweise 150° C erzeugt werden. Grundsätzlich besteht auch die Möglichkeit, die jeweilige Trennschicht 2 bzw. die diese Trennschicht aufweisende Tragplatte 1, 1a, 1b, 1c, 1d nach dem Trocknen der Trennschicht 2 bzw. Austreiben des Bindemittels weiter zu erhitzen, und zwar auf eine Temperatur unterhalb der Sintertemperatur des für die Trennschicht 2 verwendeten Trennschichtmaterials, um so eine Verfestigung der Trennschicht 2 durch teilweises Zusammenbacken der diese Trennschicht bildenden Partikel unter Beibehaltung der hohen Porosität der Trennschicht (größer 20%) zu erreichen und dadurch das Handling der jeweiligen Tragplatte 1, 1a, 1b, 1c, 1d zu vereinfachen.

Die Erfindung wurde voranstehend an Ausführungsbeispielen beschrieben. Es versteht sich, dass zahlreiche Änderungen sowie Abwandlungen möglich sind, ohne dass dadurch der durch die Patentansprüche Bestimmten Schutzbereich verlassen wird.

### Bezugszeichenliste

- 1, 1a- 1d: Tragplatte
- 2: Trennschicht
- 3: Kupferfolie oder-platte
- 4: Keramikschicht oder-platte
- 5: Kupferfolie oder -platte
- 6: DCB-Paket
- 7: rahmenartiger Abstandhalter
- 8: Abschlussplatte
- 9: Boden
- 10: Rand
- 11: Tragelement
- 12: Boden
- 13: Rand
- 14: Vertiefung
- 15: Erhebung
- 16: Vertiefung

## Patentansprüche

1. Verfahren zum Herstellen von doppelseitig metallisierten Metall-Keramik-Substraten, beispielsweise Kupfer-Keramik-Substraten unter Verwendung des Direct-Bonding-Prozesses durch Erhitzen auf eine Direct-Bonding-Temperatur,
**dadurch gekennzeichnet,**
**dass** auf einer Trennschicht (2) wenigstens eines Trägers (1, 1a, 1 b, 1c, 1d) zumindest ein DCB-Paket (6) bestehend aus einer ersten und einer zweiten Metallschicht (3, 5) und einer zwischen den Metallschichten angeordneten Keramikschicht (4) gebildet wird, wobei wenigstens eine der Metallschichten gegen die Trennschicht (2) anfliegt,
**dass** die Trennschicht von einer porösen Lage oder Schicht aus einem Trennschichtmaterial der Gruppe Mullit, Al₂O₃, TiO₃, ZrO₂, MgO, CaO, CaCO₂ oder aus einer Mischung wenigstens zweier dieser Materialien besteht,
**dass** der Träger (1, 1a, 1b, 1c, 1d) aus einem hitzebeständigen Material, beispielsweise Keramikmaterial besteht, und
**dass** das wenigstens eine auf der wenigstens einen Tragplatte (1, 1a, 1b, 1c, 1d) gebildete DCB-Paket (6) durch Erhitzen auf die Direct-Bonding-Temperatur zu wenigstens einem doppelseitig metallisierten Metall-Keramik-Substrat verbunden wird.

2. Verfahren nach Anspruch 1, **gekennzeichnet durch** die Verwendung eines Trägers (1, 1a, 1b, 1c, 1d) aus Mullit, ZrO₂, Al₂O₃, AlN, Si₃N₄, SiC oder aus einer Mischung wenigstens zweier der vorgenannten Komponenten oder eines Trägers (1, 1a, 1b, 1c, 1d) aus einem hochtemperaturfesten Metall, z.B. legierter Stahl, Molybdän, Titan, Wolfram oder aus einer Mischung wenigstens zweier der vorgenannten Komponenten.

3. Verfahren nach Anspruch 1 oder 2, **dadurch gekennzeichnet,**
**dass** die jeweilige Trennschicht (2) eine Dicke im Bereich zwischen 0,01 und 10mm aufweist.

4. Verfahren nach einem der vorhergehenden Ansprüche, **dadurch gekennzeichnet, dass** die Trennschicht (2) eine Porosität (Verhältnis Porenvolumen zu Feststoffvolumen) größer 20% besitzt.

5. Verfahren nach einem der vorhergehenden Ansprüche, **dadurch gekennzeichnet, dass** die Dicke des Trägers (1, 1 a, 1 b, 1 c, 1 d) oder des die Trennschicht (2) aufweisenden Teils des Trägers (1, 1a, 1b, 1c, 1d) im Bereich zwischen 0,2 - 10mm liegt.

6. Verfahren nach einem der vorhergehenden Ansprüche, **dadurch gekennzeichnet, dass** die Trennschicht (2) von dem pulverförmigen Trennschichtmaterial mit einer Partikelgröße kleiner als 30µm gebildet ist.

7. Verfahren nach einem der vorhergehenden Ansprüche, **gekennzeichnet durch** die Verwendung einer Tragplatte (1, 1a, 1b, 1c, 1d) als Träger oder durch die Verwendung einer Tragplatte (1, 1a, 1b, 1c, 1d), bei der die Abweichungen von einer ideal ebenen Platte kleiner 0,2% der Tragplattenlänge und/oder kleiner 0,1% der Tragplattenbreite sind.

8. Verfahren nach einem der vorhergehenden Ansprüche, **dadurch gekennzeichnet, dass** zur Bildung der Trennschicht (2) wenigstens eine Oberflächenseite des Trägers (1, 1a, 1b, 1c) mit einer Masse beschichtet wird, die beispielsweise in einer flüssigen, beispielsweise wässrigen Matrix zumindest ein Trennschichtmaterial in Pulverform enthält.

9. Verfahren nach Anspruch 8, **dadurch gekennzeichnet, dass** nach dem Aufbringen der die Trennschicht bildenden Beschichtung diese zum Trocknen und/oder zum Austreiben eines Bindungsmittels auf eine Temperatur größer als 130° C erhitzt wird.

10. Verfahren nach Anspruch 8 oder 9, **dadurch gekennzeichnet, dass** die die Trennschicht bildende Beschichtung bzw. der mit dieser Beschichtung versehene Träger (1, 1a, 1b, 1c, 1d) auf eine Temperatur größer als 150° C aber kleiner als die Sintertemperatur des Trennschichtmaterial erhitzt werden.

11. Verfahren nach einem der vorhergehenden Ansprüche, **dadurch gekennzeichnet, dass** der thermische Ausdehnungskoeffizient des Materials des wenigstens einen Trägers (1, 1a, 1b, 1c, 1d) unterschiedlich von dem thermischen Ausdehnungskoeffizienten der wenigstens einen Keramikplatte (4) des wenigstens einen DCB-Paketes (6) gewählt ist.

12. Verfahren nach einem der vorhergehenden Ansprüche, **dadurch gekennzeichnet, dass** die Metallplatten Kupferplatten oder Kupferfolien (3, 5) sind.

13. Verfahren nach einem der vorhergehenden Ansprüche, **dadurch gekennzeichnet, dass** zum Fertigen mehrerer doppelseitig metallisierter Metall-Keramik-Substrate eine Stapelanordnung mit wenigstens zwei DCB-Paketen (6) gebildet wird, von denen das untere DCB-Paket (6) auf der Trennschicht (2) eines unteren Trägers (1) aufliegt und zwischen den in der Stapelanordnung aufeinanderfolgenden DCB-Paketen (6) jeweils eine als Trennplatte wirkender Träger (1a) mit beidseitiger Trennschicht (2) vorgesehen ist.

14. Verfahren nach einem der vorhergehenden Ansprüche, **dadurch gekennzeichnet, dass** auf die Oberseite des wenigstens einen DCB-Pakets (6) ein aus dem Material der Träger (1, 1a, 1b, 1c, 1d) bestehendes und mit einer Trennschicht (2) versehenes Beschwerungselement vorgesehen ist.

15. Verfahren nach einem der vorhergehenden Ansprüche, **dadurch gekennzeichnet, dass** zur Bildung einer Stapelanordnung von mehreren DCB-Paketen (6) diese jeweils auf übereinander angeordneten Trägern (1, 1b) vorgesehen sind, und dass die Träger (1, 1b) über Abstandhalter (7, 9) voneinander beabstandet sind.

16. Verfahren nach einem der vorhergehenden Ansprüche, **dadurch gekennzeichnet, dass** das wenigstens eine DCB-Paket (6) zum Bonden in einem zumindest teilweise von der dieses DCB-Paket (6) tragenden Tragplatte (1, 1b) begrenzten Raum untergebracht ist,
und/oder
dass das wenigstens eine DCB-Paket (6) in einem wannen- oder rinnenartigen Träger (1b) angeordnet ist, und dass wenigstens zwei rinnen- oder wannenartige Träger (1 b) übereinander gestapelt vorgesehen sind,
und/oder
dass das wenigstens eine DCB-Paket (6) auf einem mit der Trennschicht (2) versehenen Träger (1) im Innenraum eines wannen- oder rinnenartigen Tragelementes (11) für das Direct-Bonden angeordnet ist und das Tragelement aus einem hitzebeständigen Material, beispielsweise Keramikmaterial besteht, vorzugsweise aus dem Material des wenigstens eines Trägers (1).

17. Verfahren nach einem der vorhergehenden Ansprüche, **dadurch gekennzeichnet, dass** die Keramik der Keramikschicht des wenigstens einen DCB-Pakets (6) aus Al₂O₃ mit einem Anteil an ZrO₂, beispielsweise mit einem Anteil zwischen 2 - 30% ZrO₂, oder aus Aluminiumnitrid (ALN) und/oder Siliziumnitrid (Si₃N₄), beispielsweise mit einer oxidischen Oberflächenschicht, z.B. aus Aluminiumoxid (Al₂O₃) besteht.

18. Verfahren nach einem der vorhergehenden Ansprüche, **dadurch gekennzeichnet, dass** die Abmessungen der wenigstens einen Keramikschicht (4) größer als 100 x 100mm sind,
und/oder
dass die Dicke der Keramikschicht des wenigstens einen DCB-Pakets (6) im Bereich zwischen 0,2 und 1,5 mm liegt,
und/oder
dass die Dicke der Metallplatten (3, 5) des wenigstens einen DCB-Pakets (6) im Bereich zwischen 0,1 - 1,2 mm liegt,
und/oder
dass das Verhältnis der Dicke der Metallschichten zu der Dicke der Keramikschicht des wenigstens einen DCB-Pakets (6) größer als 0,5 ist.

19. Verfahren nach einem der vorhergehenden Ansprüche, **dadurch gekennzeichnet, dass** die Dicke der Metallschichten (3, 5) des wenigstens einen DCB-Pakets unterschiedlich ist,
und/oder
dass der Träger (1c, 1d) an wenigstens einer die Trennschicht (2) aufweisende Seite strukturiert ist.

## Claims

1. Method for manufacturing metal-ceramic substrates metal-plated on both sides, by way of example copper-ceramic substrates by using the direct bonding process through heating to a direct-bonding temperature,
**characterised in that** at least one DCB packet (6) consisting of a first and a second metal layer (3, 5) and of a ceramic layer (4) arranged between the metal layers is formed on a separation layer (2) of at least one support (1, 1a, 1b, 1c, 1d) whereby at least one of the metal layers bears against the separation layer (2),
that the separation layer consists of a porous layer or coating of a separation layer material of the group mullite, Al₂O₃, TiO₃, ZrO₂, MgO, CaO, CaCO₂ or a mixture of at least two of these materials,
that the support (1, 1a, 1b, 1c, 1d) consists of a heat-resistant material, by way of example ceramic material, and
that the at least one DCB packet (6) formed on the at least one support plate (1, 1a, 1b, 1c, 1d) is joined to at least one double-sided metal-plated metal-ceramic substrate through heating to the direct bonding temperature.

2. Method according to claim 1 **characterised by** the use of a support (1, 1a, 1b, 1c, 1d) made of mullite, ZrO₂, Al₂O₃, AIN, Si₃N₄, SiC or of a mixture of at least two of the aforementioned components or a support (1, 1a, 1b, 1c, 1d) of a high temperature resistant metal, such as for example alloy steel, molybdenum, titanium, tungsten or of a mixture of at least two of the aforementioned components.

3. Method according to claim 1 or 2 **characterised in that** the relevant separation layer (2) has a thickness in the range from 0.01 to 10 mm.

4. Method according to one of the preceding claims **characterised in that** the separation layer (2) has a porosity (ratio of pore volume to solids volume) of greater than 20%.

5. Method according to one of the preceding claims **characterised in that** the thickness of the support (1, 1a, 1b, 1c, 1d) or of the part of the support (1, 1a, 1b, 1c, 1d) comprising the separation layer (2) is in the region of between 0.2 and 10 mm.

6. Method according to one of the preceding claims **characterised in that** the separation layer (2) is formed by the powdered separation layer material with a particle size of less than 30µm.

7. Method according to one of the preceding claims **characterised by** the use of a support plate (1, 1a, 1b, 1c, 1d) as the support or by the use of a support plate (1, 1a, 1b, 1c, 1d) in which the deviations from an ideally flat plate are less than 0.2% of the length of the support plate and/or less than 0.1 % of the width of the support plate.

8. Method according to one of the preceding claims **characterised in that** in order to form the separation layer (2) at least one surface side of the support (1, 1a, 1b, 1c) is coated with a substance mass which contains at least one separation layer material in powdered form in a fluid, by way of example aqueous, matrix.

9. Method according to claim 8 **characterised in that** after applying the coating which forms the separation layer this coating is heated to a temperature of more than 130°C in order to dry and/or expel the binding agent.

10. Method according to claim 8 or 9 **characterised in that** the coating which forms the separation layer or the support (1, 1a, 1b, 1c, 1d) which is provided with this coating is heated to a temperature which is higher than 150°C but less than the sintering temperature of the separation layer material.

11. Method according to one of the preceding claims **characterised in that** the coefficient of thermal expansion of the material of the at least one support (1, 1a, 1b, 1c, 1d) is selected to be different from the coefficient of thermal expansion of the at least one ceramic plate (4) of the at least one DCB packet (6).

12. Method according to one of the preceding claims **characterised in that** the metal plates are copper plates or copper foils (3, 5).

13. Method according to one of the preceding claims **characterised in that** to produce several metal-ceramic substrates metal-plated on both sides a stack arrangement is formed with at least two DCB packets (6) of which the lower DCB packet (6) rests on the separation layer (2) of a lower support (1) and a support (1a) acting as a separation plate with a separation layer (2) on each side is provided between each two DCB packets (6) which are stacked up on one another in the stack.

14. Method according to one of the preceding claims **characterised in that** a weighting element which consists of the material of the support (1, 1a, 1b, 1c, 1d) and is provided with a separation layer (2) is placed on the top side of the at least one DCB packet (6).

15. Method according to one of the preceding claims **characterised in that** in order to form a stack arrangement of several DCB packets (6) these are each provided on supports (1b, 1b) arranged one above the other, and that the supports (1, 1b) are spaced from one another by way of spacers (7, 9).

16. Method according to one of the preceding claims **characterised in that** the at least one DCB packet (6) is housed for bonding in a chamber defmed at least in part by the support plate (1, 1b) supporting this DCB packet (6),
and/or
that the at least one DCB packet (6) is disposed in a trough or channel-like support (1b), and that at least two channel or trough-like supports (1b) are provided stacked one above the other,
and/or
that the at least one DCB packet (6) is mounted on a support (1) provided with the separation layer (2) in the interior of a trough or channel-like support element (11) for the direct bonding and the support element is made from a heat-resistant material, by way of example ceramic material, preferably from the material of the at least one support (1).

17. Method according to one of the preceding claims **characterised in that** the ceramic of the ceramic layer of the at least one DCB packet (6) consists of Al₂O₃ with a proportion of ZrO₂, by way of example with a proportion between 2 and 30% ZrO₂, or of aluminium nitride (ALN) and/or silicon nitride (Si₃N₄), by way of example with an oxidic surface layer, e.g. of aluminium oxide (Al₂O₃).

18. Method according to one of the preceding claims **characterised in that** the dimensions of the at least one ceramic layer (4) are greater than 100 × 100 mm, and/or
that the thickness of the ceramic layer of the at least one DCB packet (6) lies in the range between 0.2 and 1.5 mm,
and/or
that the thickness of the metal plates (3, 5) of the at least one DCB packet (6) lies in the range between 0.1 and 1.2 mm,
and/or
that the ratio of the thickness of the metal layers to the thickness of the ceramic layer of the at least one DCB packet (6) is greater than 0.5.

19. Method according to one of the preceding claims **characterised in that** the thickness of the metal layers (3, 5) of the at least one DCB packet is different, and/or that the support (1c, 1d) is structured on at least one side comprising the separation layer (2).

## Revendications

1. Procédé de fabrication de substrats métal/céramique métallisés sur les deux faces, par exemple de substrats de cuivre/céramique en utilisant le procédé de direct bonding par chauffage à une température de direct bonding,
**caractérisé en ce**
**qu'**un paquet DCB (6) composé de première et deuxième couches métalliques (3, 5) et d'une couche céramique (4) disposée entre les couches métalliques est au moins formé sur une couche de séparation (2) d'au moins un support (1, 1a, 1b, 1c, 1d), une des couches métalliques au moins étant appliquée contre la couche de séparation (2),
**que** la couche de séparation se compose d'une couche poreuse d'un matériau de couche de séparation du groupe mullite, Al₂O₃, TiO₃, ZrO₂, MgO, CaO, CaCO₂ ou d'un mélange d'au moins deux de ces matériaux,
**que** le support (1, 1a, 1b, 1c, 1d) se compose d'un matériau résistant à la chaleur, par exemple d'un matériau céramique, et
**que** le paquet DCB au moins formé sur au moins une plaque de support (1, 1a, 1b, 1c, 1d) est lié par chauffage à la température de direct bonding à au moins un substrat métal/céramique métallisé sur deux faces.

2. Procédé selon la revendication 1, **caractérisé par** l'utilisation d'un support (1, 1a, 1b, 1c, 1d) de mullite, Al₂O₃, TiO₃, ZrO₂, MgO, CaO, CaCO₂ ou d'un mélange d'au moins deux des composants précités ou d'un support (1, 1 a, 1b, 1c, 1d) en un métal résistant aux températures élevées, par exemple d'un alliage d'acier, de molybdène, de titane, de tungstène ou d'un mélange d'au moins deux des composants précités.

3. Procédé selon l'une de revendications 1 ou 3, **caractérisé en ce que** la couche de séparation (2) respective présente une épaisseur de l'ordre de 0,01 à 10 mm.

4. Procédé selon l'une des revendications précédentes, **caractérisé en ce que** la couche de séparation (2) possède une porosité (rapport volume des pores/volume de matière solide) supérieure à 20 %.

5. Procédé selon l'une des revendications précédentes, **caractérisé en ce que** l'épaisseur du support (1, 1a, 1b, 1c, 1d) ou de la partie du support (1, 1a, 1b, 1c, 1d) présentant la couche de séparation (2) est de l'ordre de 0,2 à 10 mm.

6. Procédé selon l'une des revendications précédentes, **caractérisé en ce que** la couche de séparation (2) est formée par le matériau pulvérulent de couche de séparation d'un diamètre des particules inférieur à 30 µm.

7. Procédé selon l'une des revendications précédentes, **caractérisé par** l'utilisation d'une plaque de support (1, 1a, 1b, 1c, 1d) comme support ou par l'utilisation d'une plaque de support (1, 1a, 1b, 1c, 1d) dans laquelle les écarts par rapport à une plaque plane idéale sont inférieurs à 0,2 % de la longueur de la plaque de support et/ou inférieurs à 0,1 % de la largeur de la plaque de support.

8. Procédé selon l'une de revendications précédentes, **caractérisé en ce qu'**au moins une face de la surface du support (1, 1a, 1b, 1c, 1d) est revêtue d'une masse qui contient par exemple au moins un matériau de couche de séparation sous forme pulvérulente dans une matrice liquide, de préférence aqueuse, pour la formation de la couche de séparation (2).

9. Procédé selon la revendication 8, **caractérisé en ce qu'**après l'application du revêtement formant la couche de séparation, celui-ci est chauffé en vue de son séchage et/ou de l'expulsion d'un agent liant à une température supérieure à 130° C.

10. Procédé selon l'une des revendications 8 ou 9 **caractérisé en ce que** le revêtement formant la couche de séparation ou le support doté de ce revêtement (1, 1a, 1b, 1c, 1d) sont chauffés à une température supérieure à 150° C mais inférieure à la température de frittage du matériau de la couche de séparation.

11. Procédé selon l'une des revendications précédentes **caractérisé en ce que** le coefficient de dilatation thermique du matériau d'au moins un support (1, 1a, 1b, 1 c, 1d) est différent du coefficient de dilatation thermique d'au moins une plaque céramique (4) d'au moins un paquet DCB (6).

12. Procédé selon l'une des revendications précédentes **caractérisé en ce que** les plaques métalliques sont des plaques de cuivre ou des feuilles de cuivre (3, 5).

13. Procédé selon l'une des revendications précédentes **caractérisé en ce que**, pour la confection de plusieurs substrats métal/céramique métallisés sur deux faces, il est formé un agencement empilé d'au moins deux paquets DCB (6), le paquet DCB inférieur (6) étant appliqué sur la couche de séparation (2) d'un support inférieur (1) et un support (1a) avec une couche de séparation (2) sur les deux faces qui fait office de plaque de séparation étant prévu respectivement entre les paquets DCB (6) superposés dans l'agencement empilé.

14. Procédé selon l'une des revendications précédentes, **caractérisé en ce qu'**un élément de charge doté d'une couche de séparation (2) et composé du matériau du support (1, 1a, 1b, 1c, 1d) est prévu sur la face supérieure d'au moins un paquet DCB (6).

15. Procédé selon l'une des revendications précédentes, **caractérisé en ce que**, pour la formation d'un agencement empilé de plusieurs paquets DCB (6), ceux-ci sont prévus respectivement sur des supports (1, 1b) superposés et que les supports (1, 1b) sont espacés l'un de l'autre par l'intermédiaire de pièces d'écartement (7, 9).

16. Procédé selon l'une des revendications précédentes, **caractérisé en ce que** le paquet DCB (6) au moins est disposé pour le bonding dans un espace délimité, du moins partiellement, par la plaque de support (1, 1b) portant ce paquet (6, 6b)
et/ou
que le paquet DCB (6) au moins est disposé dans un support (1b) en forme de cuvette ou de rainure et qu'au moins deux supports (1b) en forme de cuvette ou de rainure sont superposés et/ou que le paquet DCB (6) au moins est disposé sur un support (1) doté de la couche de séparation (2) dans l'espace intérieur d'un élément de support (11) en forme de cuvette ou de rainure pour le direct bonding et que l'élément de support est composé d'un matériau résistant à la chaleur, par exemple d'un matériau céramique, de préférence du matériau d'au moins un support (1).

17. Procédé selon l'une de revendications précédentes, **caractérisé en ce que** la céramique de la couche céramique du paquet DCB (6) au moins se compose d'Al₂O₃ avec une part de ZrO₂, par exemple avec une part située entre 2 et 30 % de ZrO₂ ou de nitrure d'aluminium (AlN) et/ou de nitrure de silicium (Si₃N₄), par exemple avec une couche superficielle oxydée, par exemple en oxyde d'aluminium (Al₂O₃₎.

18. Procédé selon l'une des revendications précédentes **caractérisé en ce que** les dimensions de la couche céramique (4) au moins sont supérieures à 100 x 100 mm,
et/ou
que l'épaisseur de la couche céramique d'au moins un paquet DCB (6) se situe dans une plage située entre 0,2 et 1,5 mm
et/ou
que l'épaisseur des plaques métalliques (3, 5) d'au moins un paquet DCB (6) se situe dans une plage située entre 0,1 et 1,2 mm,
et/ou
que le rapport de l'épaisseur des couches métalliques à l'épaisseur de la couche céramique d'au moins un paquet DCB (6) est supérieure à 0,5.

19. Procédé selon l'une des revendications précédentes, **caractérisé en ce que** l'épaisseur des couches métalliques (3, 5) d'au moins un paquet DCB est différente
et/ou
que le support (1c, 1d) est structuré sur au moins une face présentant la couche de séparation (2).
